# EUROPEAN PATENT APPLICATION

(11) **EP 2 367 411 A2**
(43) Date of publication of application: **21.09.2011**
(21) Application number: 10191920.7
(22) Date of filing: 19.11.2010
(51) Int. Cl.: H05K 7/04

(54) **Display apparatus and electronic apparatus**

(30) Priority: 17.03.2010 JP 2010061542
(71) Applicant: Kabushiki Kaisha Toshiba, Minato-ku Tokyo 105-8001 (JP)
(72) Inventor: Harita, Keisuke, Tokyo Tokyo 105-8001 (JP)
(74) Representative: Henkel, Breuer & Partner

(57) **Abstract**

According to one embodiment, a display apparatus includes a housing (2), a holder (12a, 12b) in the housing (2), a circuit board (11) attached to the holder (12a, 12b), an insulator (13), and an interposed portion (33). The insulator (13) includes a first portion (31) facing the circuit board (11) and a second portion (32) facing the holder (12a, 12b). The interposed portion (33) is interposed between the circuit board (11) and the first portion (31) of the insulator (13) and presses the first portion (31) in a direction in which the second portion (32) is pressed against the holder (12a, 12b).

## Description

Embodiments described herein relate generally to a display apparatus and an electronic apparatus which include an insulator.

Some display apparatuses and electronic apparatuses include insulators.

Jpn. Pat. Appln. KOKAI Publication No. 2009-49245 discloses an electric apparatus including an insulating sheet. The insulating sheet is fixed to a supporting member by a fixing member such as a double-sided tape.

A general architecture that implements the various feature of the embodiments will now be described with reference to the drawings. The drawings and the associated descriptions are provided to illustrate the embodiments and not to limit the scope of the invention.
FIG. 1 is an exemplary perspective view illustrating a display apparatus according to a first embodiment.
FIG. 2 is an exemplary rear view illustrating the inside of the display apparatus shown in FIG. 1.
FIG. 3 is an exemplary exploded perspective view illustrating a mounting structure of a circuit board shown in FIG. 2.
FIG. 4 is an exemplary perspective view illustrating a pair of holders shown in FIG. 3.
FIG. 5 is an exemplary perspective view illustrating a region surrounded by a line F5 in the holder shown in FIG. 4.
FIG. 6 is an exemplary perspective view illustrating an insulator shown in FIG. 3.
FIG. 7 is an exemplary perspective view illustrating a region surrounded by a line F7 in the insulator shown in FIG. 6.
FIG. 8 is an exemplary perspective view illustrating the attachment of the insulator to the holder shown in FIG. 3.
FIG. 9 is an exemplary perspective view illustrating a region surrounded by a line F9 in a mounting structure shown in FIG. 8.
FIG. 10 is an exemplary perspective view illustrating the mounting structure shown in FIG. 9, as viewed from a different angle.
FIG. 11 is an exemplary perspective view illustrating the attachment of the circuit board to the mounting structure shown in FIG. 8.
FIG. 12 is an exemplary perspective view illustrating a region surrounded by a line F12 in the mounting structure shown in FIG. 11.
FIG. 13 is an exemplary plan view illustrating the mounting structure shown in FIG. 3.
FIG. 14 is an exemplary cross-sectional view illustrating the mounting structure taken along the line F14-F14 of FIG. 13.
FIG. 15 is an exemplary cross-sectional view illustrating the mounting structure taken along the line F15-F15 of FIG. 13.
FIG. 16 is an exemplary perspective view illustrating an electronic apparatus according to a second embodiment.

Various embodiments will be described hereinafter with reference to the accompanying drawings.

In general, according to one embodiment, a display apparatus comprises a housing, a holder in the housing, a circuit board attached to the holder, an insulator, and an interposed portion. The insulator comprises a first portion facing the circuit board and a second portion facing the holder. The interposed portion is interposed between the circuit board and the first portion of the insulator and presses the first portion in a direction in which the second portion is pressed against the holder.

Hereinafter, exemplary embodiments applied to a television and a notebook personal computer (hereinafter, referred to as a notebook PC) will be described with reference to the accompanying drawings.

### (First embodiment)

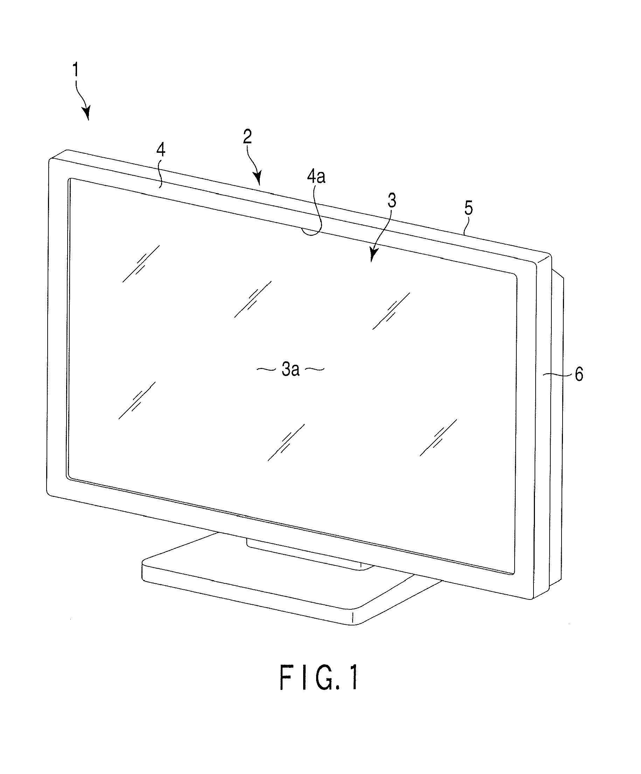

First, a first embodiment will be described with reference to FIGS. 1 to 15.

FIG. 1 shows a display apparatus 1 according to the first embodiment. The display apparatus 1 is, for example, a television. The display apparatus to which this embodiment can be applied is not limited thereto. This embodiment can be widely applied to various kinds of display apparatuses.

The display apparatus 1 includes a housing 2 and a display panel 3 in the housing 2. The housing 2 is made of, for example, a synthetic resin and has a flat box shape. The display panel 3 is, for example, a liquid crystal display (LCD), a plasma display, or an organic electroluminescent display (organic EL display).

As shown in FIG. 1, the housing 2 includes a front wall 4, a rear wall 5, and a circumferential wall 6. The front wall 4 faces the user and includes an opening portion 4a. A display screen 3a of the display panel 3 is exposed to the outside of the housing 2 through the opening portion 4a. The rear wall 5 rises on the rear side of the display panel 3 and faces the display panel 3 on the side opposite to the front wall 4. The circumferential wall 6 connects the edge of the front wall 4 and the edge of the rear wall 5.

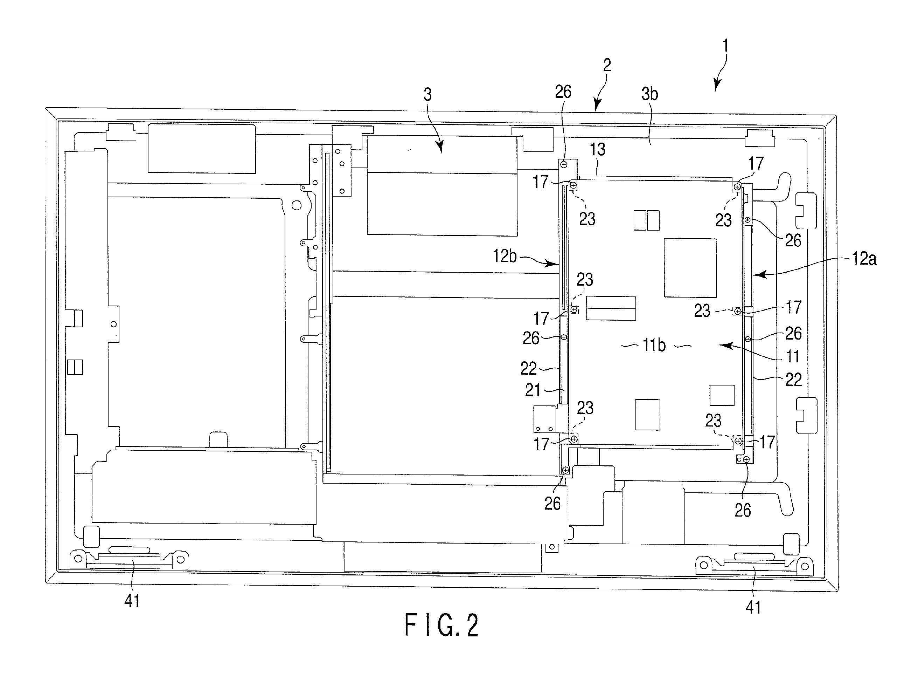

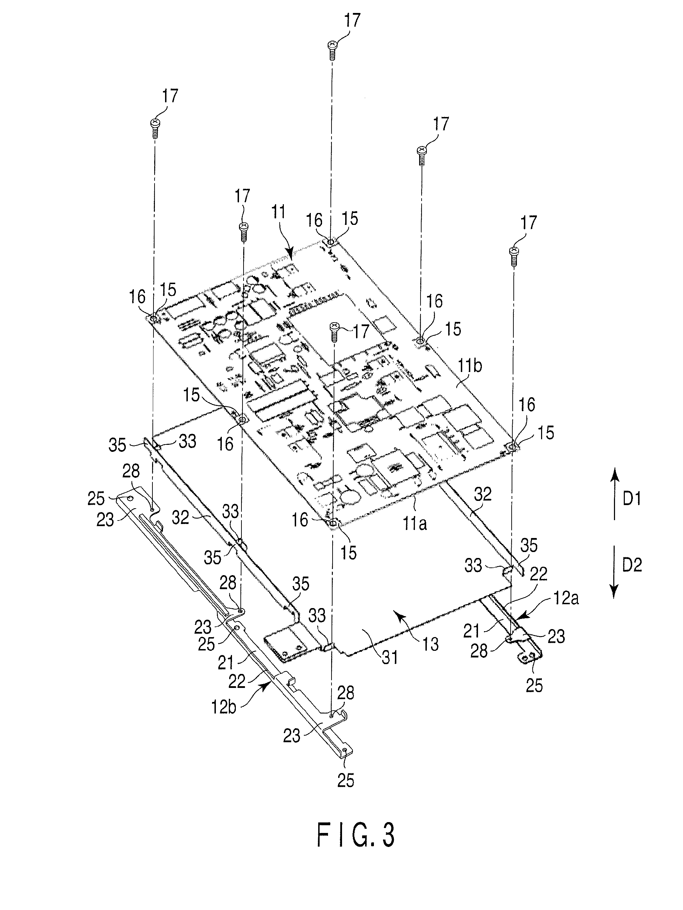

FIG. 2 is a rear view illustrating the inside of the housing 2. As shown in FIG. 2, a circuit board 11 is mounted on a rear surface 3b of the display panel 3. The circuit board 11 is, for example, a power supply board. As shown in FIG. 3, the circuit board 11 is attached to the display panel 3 via a pair of holders 12a and 12b and an insulator 13. This mounting structure will be described in detail below.

First, the circuit board 11 will be described. As shown in FIGS. 2 and 3, the circuit board 11 is, for example, a rectangular plate. The circuit board 11 includes a first surface 11a facing the display panel 3 and a second surface 11b opposite to the first surface 11a. Each component of the power supply circuit is on, for example, the second surface 11b.

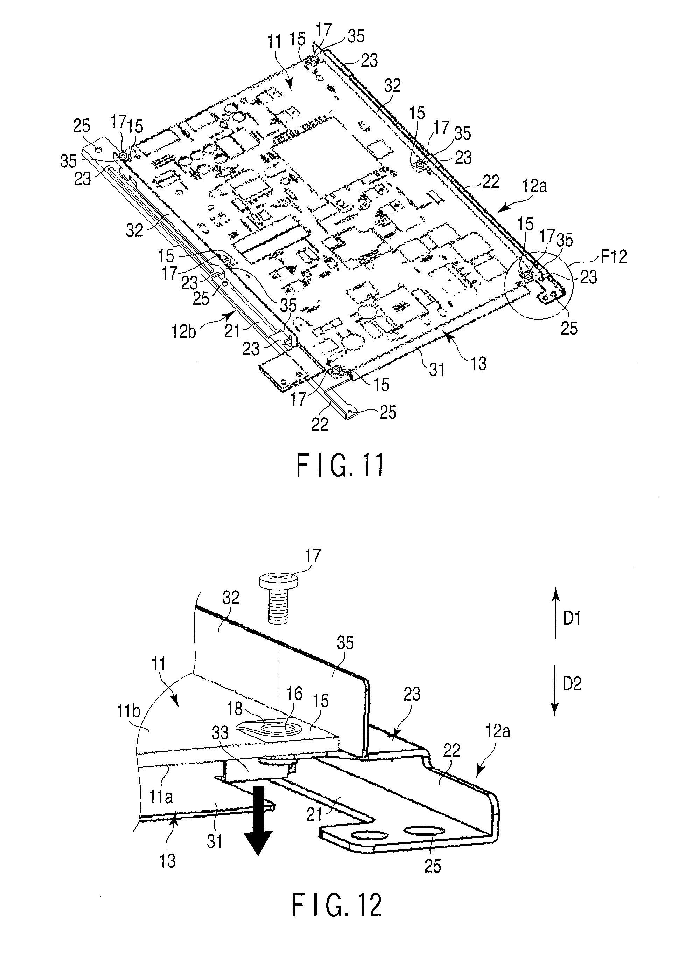

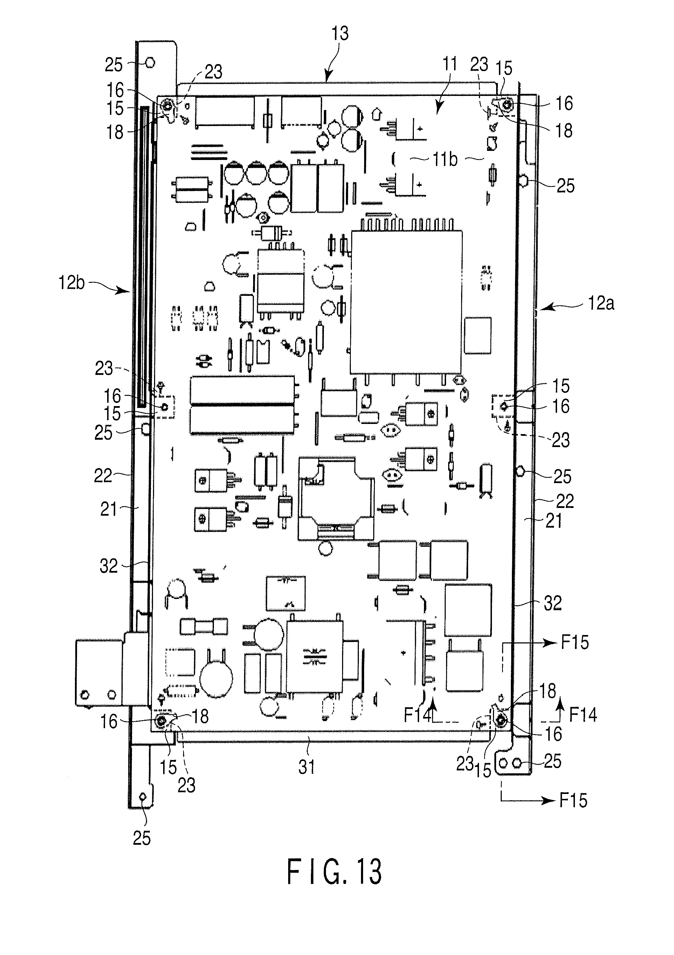

The circuit board 11 includes fixing portions 15 at four corner portions and the center portions of the edge portions of the circuit board 11 in the longitudinal direction. The fixing portions 15 are fixed to the holders 12a and 12b. The fixing portion 15 includes an insertion hole 16. For example, the insertion hole 16 passes from the second surface 11b to the first surface 11a such that a screw 17 can be inserted into the insertion hole 16. As shown in FIGS. 12 and 13, the fixing portions 15 at four corners of the circuit board 11 each include a conductive portion 18. The conductive portion 18 is electrically connected to the ground of the circuit board 11. The conductive portion 18 is a part of the ground path that connects the ground of the circuit board 11 to the outside of the circuit board 11. The conductive portion 18 is provided next to the insertion hole 16, for example, the circumference of the insertion hole 16.

For example, the conductive portion 18 slightly protrudes from the second surface 11b. The screws 17 for fixing the circuit board 11 are engaged with the holders 12a and 12b through the insertion holes 16. In this case, the head portion of the screw 17 comes into contact with the conductive portion 18. In this way, the ground of the circuit board 11 is electrically connected to the holders 12a and 12b through the conductive portions 18 and the screws 17. In this way, the grounding of the circuit board 11 is ensured. Alternatively, the conductive portion 18 may be provided on the first surface 11a.

As shown in FIG. 2, the pair of holders 12a and 12b (hereinafter, referred to as the first and second holders 12a and 12b) is fixed to the rear surface 3b of the display panel 3 and is contained in the housing 2. The first and second holders 12a and 12b are, for example, brackets (attachment brackets). Each of the first and second holders 12a and 12b is attached to the circuit board 11 and is an example of a supporting portion supporting the circuit board 11. The first and second holders 12a and 12b extend in the vertical direction and are separated from each other in the horizontal direction with a gap corresponding to the width of the circuit board 11 therebetween.

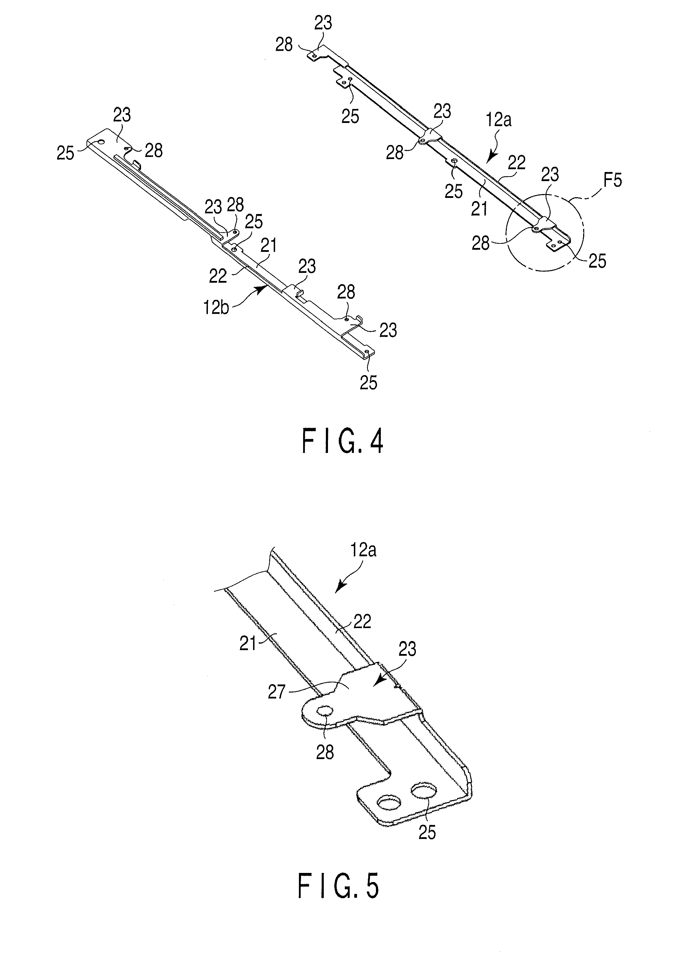

As shown in FIG. 4, each of the first and second holders 12a and 12b includes an attachment portion 21 (i.e., first portion), a rising portion 22 (i.e., second portion), and holding portions 23 (i.e., third portion). FIG. 5 shows in detail the attachment portion 21, the rising portion 22, and the holding portion 23 at the end portion of the first holder 12a. The other first, second and third portions 21, 22 and 23 of the first holder 12a and the second holder 12b have substantially the same structure as that shown in FIG. 5.

As shown in FIG. 4, the attachment portion 21 is a plate-shaped portion that is substantially parallel to the rear surface 3b of the display panel 3 and is attached to the rear surface 3b. For example, the attachment portion 21 is longer than the circuit board 11 in the longitudinal direction of the circuit board 11. The attachment portion 21 includes a plurality of insertion holes 25 and is fixed to the display panel 3 by, for example, screws 26 (see FIG. 2). The screw 26 is an example of a fixing member fixing the holders 12a and 12b. Alternatively, the holders 12a and 12b may be fixed by other fixing members such as rivets.

The rising portion 22 is provided in the edge portion of the attachment portion 21 extending in the longitudinal direction and rises with respect to the attachment portion 21. The rising portion 22 rises in a direction away from the display panel 3. For example, the rising portion 22 is provided over the entire length of the attachment portion 21 in the longitudinal direction. The rising portion 22 functions as a beam and gives rigidity to the holders 12a and 12b.

As shown in FIG. 4, the holding portions 23 are partially provided over the entire length of each of the holders 12a and 12b (for example, six holding portions 23 are provided). The holding portions 23 are at both end portions of each of the holders 12a and 12b in the longitudinal direction and at the center portions of the holders 12a and 12b so as to face the fixing portions 15 of the circuit board 11.

As shown in FIG. 5, the holding portion 23 protrudes from the leading end portion of the rising portion 22 substantially in parallel to the attachment portion 21. The holding portion 23 is a protruding portion that protrudes in a fin shape. For example, the attachment portion 21, the rising portion 22, and the holding portions 23 are integrally formed by bending one metal sheet.

The holding portion 23 includes a mounting surface 27 on which the circuit board 11 is mounted and a fitting hole 28 formed in the mounting surface 27. The mounting surface 27 extends substantially in parallel to the attachment portion 21. The fitting hole 28 is, for example, a screw hole. The fitting hole 28 faces the insertion hole 16 of the circuit board 11. As shown in FIG. 12, the screw 17 is inserted into the fitting hole 28 through the insertion hole 16 to fix the circuit board 11 to the holding portion 23. The screw 17 is an example of the fixing member fixing the circuit board 11. Alternatively, the circuit board may be fixed by, for example, other fixing members such as rivets.

As shown in FIG. 3, the insulator 13 is, for example, an insulating sheet made of a synthetic resin and is an example of an insulating portion. The insulator has elasticity. The insulator 13 includes a first portion 31, second portions 32, and third portions 33.

As shown in FIG. 3, the first portion 31 is a main portion of the insulator 13 and is also a cover portion covering the circuit board 11. The first portion 31 is substantially parallel to the circuit board 11 and faces the circuit board 11 in the direction (first direction D1) from the holders 12a and 12b to the circuit board 11. The first portion 31 has a rectangular plate shape. The first portion 31 has a size extending between the first and second holders 12a and 12b. The first portion 31 is disposed between the circuit board 11 and the display panel 3 and covers substantially the entire surface of the circuit board 11.

The first portion 31 includes four edge portions 31a, 31b, 31c, and 31d (hereinafter, referred to as first to fourth edge portions 31a, 31b, 31c, and 31d). The first and second edge portions 31a and 31b extend in the longitudinal direction of the insulator 13 along the first and second holders 12a and 12b. The third and fourth edge portions 31c and 31d extend in a direction orthogonal to the first and second edge portions 31a and 31b and connect the first and second edge portions 31a and 31b with each other.

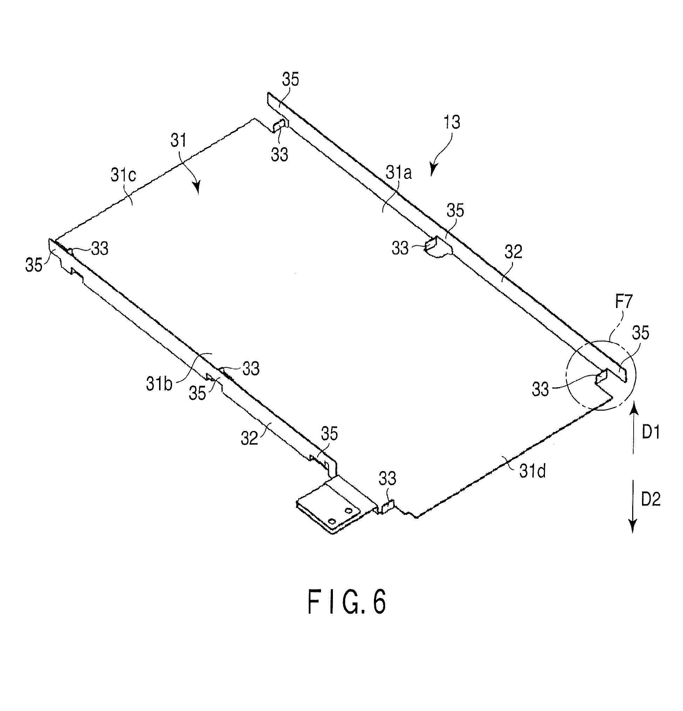

As shown in FIG. 6, the second portion 32 is a rising portion of the insulator 13 and rises with respect to the first portion 31. The second portions 32 are provided in the first and second edge portions 31a and 31b of the first portion 31 and extend over substantially the entire length of the insulator 13 in the longitudinal direction of the insulator 13. The second portions 32 extend along the outlines of the first and second holders 12a and 12b. As shown in FIG. 12, the second portions 32 rise on the side of the circuit board 11 over the entire length of the circuit board 11 in the longitudinal direction.

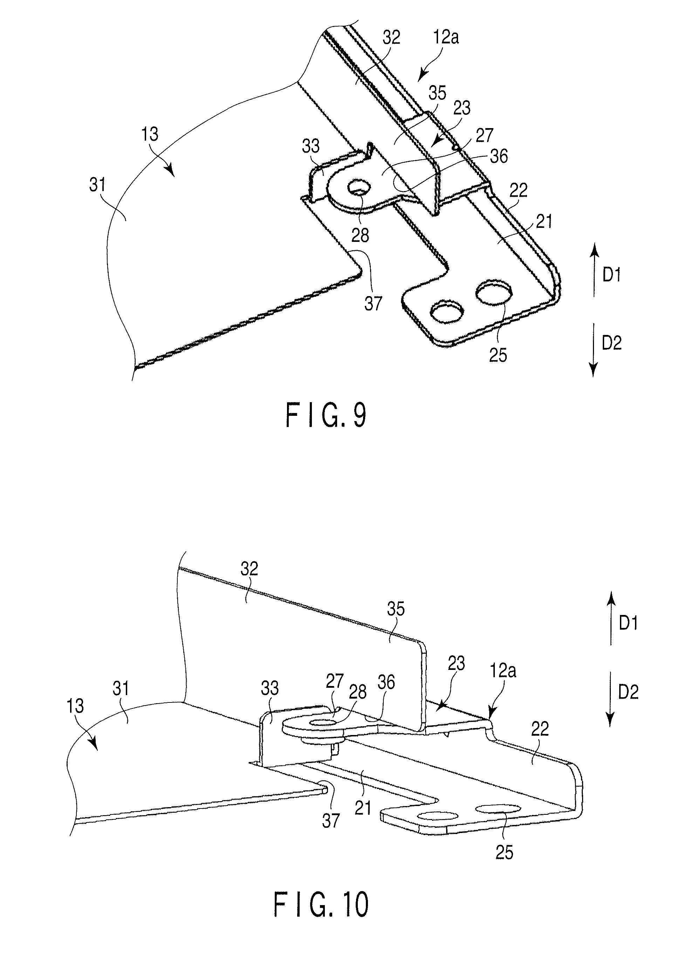

As shown in FIGS. 9 and 10, the second portions 32 face the holders 12a and 12b. The second portions 32 are mounted on the holding portions 23 of the holders 12a and 12b and are supported by the holding portions 23. The second portion 32 faces the holding portion 23 in a second direction D2. The second direction D2 is different from the first direction D1. In this embodiment, the second direction D2 is from the circuit board 11 to the holders 12a and 12b and is opposite to the first direction D1.

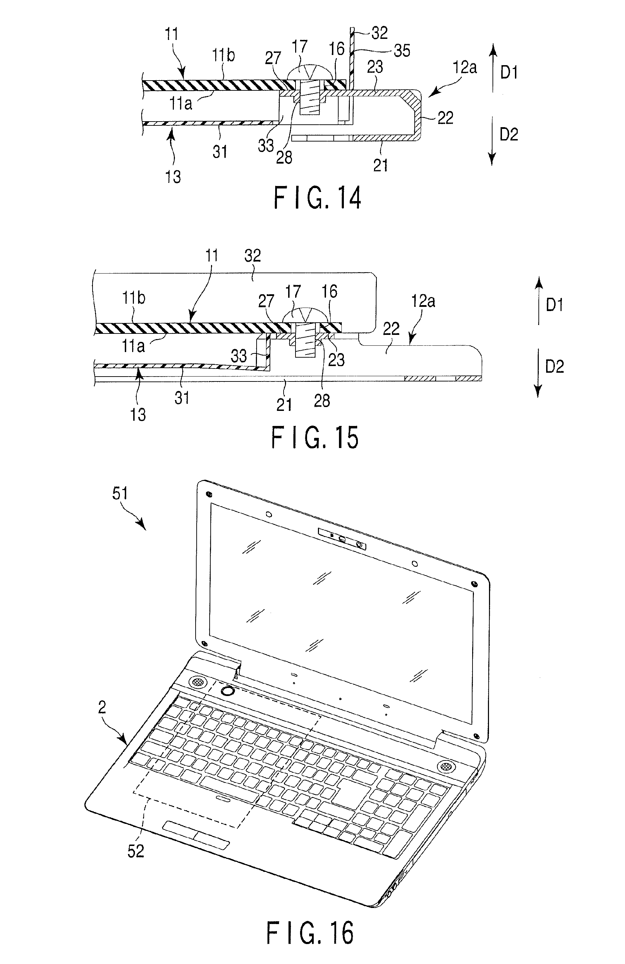

That is, the second portion 32 is supported by the holding portions 23 in the first direction D1. As shown in FIG. 14, the second portion 32 comes into contact with the holding portion 23 substantially in the right-angled direction and has relatively high rigidity in the supporting direction of the holding portion 23 (first direction D1). That is, the second portion 32 has rigidity higher than the first portion 31 in the supporting direction of the holding portion 23.

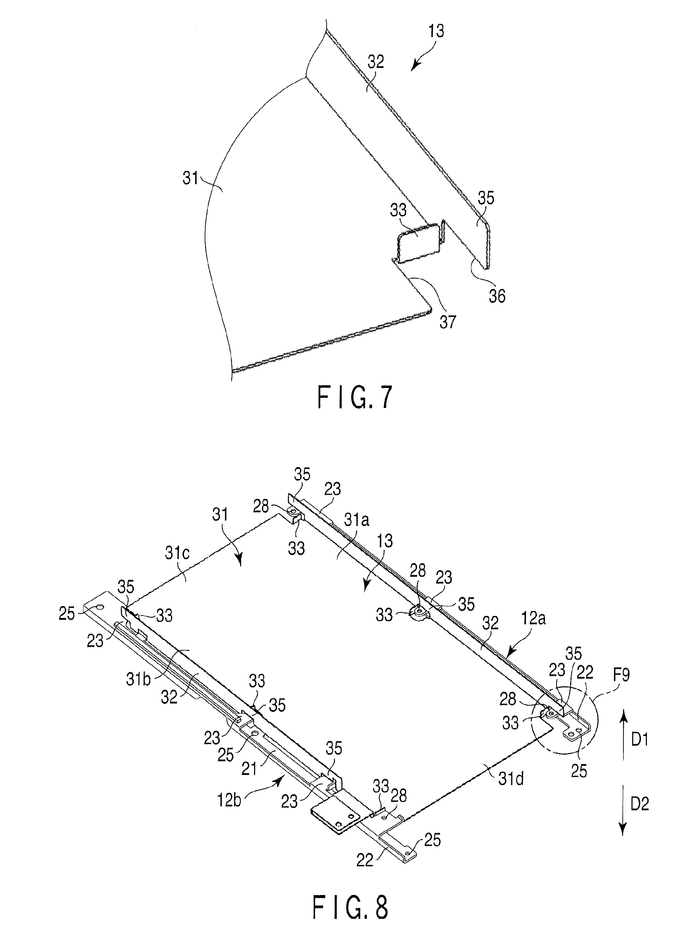

As shown in FIGS. 7, 9, and 10, the second portion 32 includes fitting portions 35 (i.e., receivers) fitted to the holding portions 23 of each of the holders 12a and 12b. The fitting portion 35 includes a first cut-out portion 36 and has a concave shape. The first cut-out portion 36 is formed by cutting out the end portion of the second portion 32 so as to avoid the holding portion 23. When the holding portions 23 is inserted into the first cut-out portions 36, the insulator 13 is supported by the holding portions 23 at the position where the first portion 31 is closer to the display panel 3 than the holding portions 23 is.

The first portion 31 includes second cut-out portions 37. The second cut-out portions 37 are provided so as to correspond to the holding portions 23 of the holders 12a and 12b. Each of the second cut-out portions 37 is formed by cutting out the end portion of the first portion 31 so as to avoid the holding portion 23. When the holding portions 23 is inserted into the second cut-out portions 37, the first portion 31 of the insulator 13 is disposed closer to the display panel 3 than the holding portion 23 is. The second cut-out portion 37 is connected to the first cut-out portion 36.

As shown in FIGS. 7, 9, and 10, the third portion 33 rises from the edge portion of the second cut-out portion 37. The third portion 33 is an example of an "interposed portion". The third portion 33 according to this embodiment is formed by bending a portion of the insulator 13, which is a sheet. That is, in this embodiment, the first to third portions 31, 32, and 33 are integrally formed by bending a sheet made of a synthetic resin.

As shown in FIGS. 12 and 15, the third portion 33 protrudes from the first portion 31 to the circuit board 11. As shown in FIG. 10, when the circuit board 11 is not attached, the third portion 33 protrudes over the holding portion 23 of each of the holders 12a and 12b. That is, the leading end portion of the third portion 33 protrudes from the mounting surface 27 of the holding portion 23 slightly (for example, several millimeters).

Therefore, when the circuit board 11 is mounted on the holding portions 23, the third portion 33 is interposed between the circuit board 11 and the first portion 31 and presses the first portion 31 in the direction (second direction D2) in which the second portions 32 are pressed against the holders 12a and 12b (see an arrow in FIG. 12).

Specifically, when the circuit board 11 is mounted on the holding portions 23, the third portions 33 come into contact with the first surface 11a of the circuit board 11 and are pressed in a distance corresponding to the interference toward the first portion 31 by the circuit board 11. In this way, the third portions 33 are displaced so as to press the first portion 31 in the second direction D2, and the entire insulator 13 is pressed in the second direction D2.

Since the second portion 32 is provided on the holding portions 23 and is supported by the holding portions 23, the second portion 32 cannot be displaced. Therefore, the first portion 31 is elastically deformed to absorb the displacement of the third portions 33. In this way, the insulator 13 is interposed between the circuit board 11 and the holders 12a and 12b and fixed between the circuit board 11 and the holders 12a and 12b. That is, the second portion 32 and the third portion 33 come into contact with the holders 12a and 12b and the circuit board 11 in the opposite direction, and the movement of the insulator 13 is regulated.

In this embodiment, the third portions 33 are provided in one-to-one correspondence with the holding portions 23 of the holders 12a and 12b. That is, the third portions 33 are provided in one-to-one correspondence with the fitting portions 35 of the second portions 32.

In this embodiment, the "interposed portion" is a portion of the insulator 13, but the embodiment is not limited thereto. Alternatively, the interposed portion may be, for example, a protrusion on the first surface 11a of the circuit board 11 or a spacer (for example, a sponge member) between the circuit board 11 and the insulator 13.

As shown in FIG. 2, the housing 2 contains speakers 41 therein. The speaker 41 is provided next to the insulator 13. For example, the speaker 41 provided is in a lower portion of the housing 2 and below the circuit board 11 and the insulator 13. For example, the speaker 41 is arranged with a cone (i.e., diaphragm) facing downward and outputs sound to the lower side of the housing 2.

Therefore, when the sound is output, vibration (i.e., reaction) is likely to be transmitted to, for example, the insulator 13 above the speaker 41. The "the speaker is next to the insulator" means that the insulator is in the range in which it is affected by vibration from the speaker.

Next, a method of assembling the display apparatus 1 will be described. The assembly method is substantially the same as a method of assembling other display apparatuses except for the mounting structure of the insulator 13. Therefore, the mounting structure of the insulator 13 will be described in detail below.

First, the display panel 3 is prepared with the rear surface 3b facing upward. Then, the first and second holders 12a and 12b are attached to the display panel 3. Specifically, the insertion holes 25 in the first portions 31 of the holders 12a and 12b are aligned with the fitting holes (for example, screw holes (not shown)) in the rear surface 3b of the display panel 3. Then, the screws 26 are inserted into the fitting holes of the display panel 3 through the insertion holes 25 of the holders 12a and 12b. In this way, the holders 12a and 12b are fixed to the display panel 3 and the positions of the holders 12a and 12b are determined.

Then, as shown in FIG. 8, the insulator 13 is mounted on the holders 12a and 12b. Specifically, the holding portions 23 of the holders 12a and 12b sequentially pass through the second cut-out portions 37 and the first cut-out portions 36 such that the first portion 31 of the insulator 13 is arranged closer to the display panel 3 than the holding portions 23 is. Then, the second portions 32 are mounted on the mounting surfaces 27 of the holding portions 23 and the insulator 13 is supported. That is, the insulator 13 is mounted on the holders 12a and 12b without using any fixing member, such as a screw or a double-sided tape.

Then, as shown in FIG. 11, the circuit board 11 is attached to the holders 12a and 12b. Specifically, the insertion holes 16 of the circuit board 11 are aligned with the fitting holes 28 of the holders 12a and 12b. Then, the screws 17 are inserted into the fitting holes 28 through the insertion holes 16 to fix the circuit board 11 to the holding portions 23 of the holders 12a and 12b. In this case, the circuit board 11 comes into contact with the third portions 33 of the insulator 13 to press the third portions 33 to the display panel 3. As a result, the second portions 32 of the insulator 13 are pressed to the holding portions 23 of the holders 12a and 12b. In this way, the insulator 13 is fixed between the holders 12a and 12b and the circuit board 11.

As described above, in the structure according to this embodiment, it is possible to perform a mounting process only by sequentially stacking the holders 12a and 12b, the insulator 13, and the circuit board 11 on the display panel 3.

Next, the operation of the display apparatus 1 according to this embodiment will be described.

In the display apparatus or the electronic apparatus, it is necessary to maintain a predetermined distance or more between the circuit board 11, which is a power supply board, and the display panel 3 or the holders 12a and 12b (a so-called distance between the primary side and the secondary side) in terms of safety, such as the prevention of a short-circuit. In the case where it is difficult to maintain the predetermined distance as a linear distance, a nonconductive material, such as an insulating sheet, is interposed therebetween to maintain the distance as a spatial distance. In this embodiment, the insulator 13 is between the circuit board 11, and the display panel 3 and the holders 12a and 12b to ensure a predetermined spatial distance or more.

According to the display apparatus 1 having the above-mentioned structure, it is possible to reduce the number of components. That is, when there are the insulator 13 including the first portion 31 facing the circuit board 11 and the second portion 32 facing the holder 12a, and the interposed portions 33 interposed between the circuit board 11 and the first portion 31 and pressing the first portion 31 in a direction in which the second portion 32 is pressed against the holder 12a, it is possible to fix the insulator 13 without using a fixing member, such as a screw or a double-sided tape.

In this way, it is possible to reduce the number of fixing members, such as screws or double-sided tapes. When the number of fixing members can be reduced, it is possible to improve the workability of the assembly process or reduce costs. In particular, in the structure according to this embodiment, it is possible to form a mounting structure only by sequentially stacking the holders 12a and 12b, the insulator 13, and the circuit board 11 on the display panel 3 from the upper side. Therefore, it is possible to achieve high workability.

When the interposed portion 33 is a portion of the insulator 13, it is possible to reduce the number of components, as compared to the structure in which, for example, a protrusion or a spacer provided on the circuit board 11 is used as the interposed portion. In this way, it is possible to further improve the workability of the assembly process or reduce costs. Since the interposed portion 33 is formed by bending a portion of the insulating sheet, it is possible to simplify an operation related to the interposed portion 33 or further reduce costs.

When the insulator 13 has elasticity, it is possible to interpose the insulator 13 between the circuit board 11 and the holders 12a and 12b without any large stress to the insulator 13, the circuit board 11, or the holders 12a and 12b due to interference.

It may possible to reduce the number of fixing members in the structure in which the insulator is hooked to the circuit board 11 without using, for example, a screw or a double-sided tape. However, in this case, since the insulator 13 is just hooked, the insulator 13 is likely to resonate with the speaker 41 and noise is likely to be generated. In particular, the influence of noise is large in the structure in which the speaker 41 faces downward and vibration from the speaker 41 is likely to be transmitted to the insulator 13, as in this embodiment.

In contrast, according to this embodiment, the insulator 13 comes into contact with both the circuit board 11 and the holders 12a and 12b. That is, the insulator 13 is interposed and fixed between the circuit board 11 and the holders 12a and 12b. As such, when the insulator 13 is strongly fixed, the insulator 13 is less likely to resonate with the speaker 41 and noise is less likely to be generated. This is particularly effective in the structure in which the speaker 41 faces downward and vibration from the speaker 41 is likely to be transmitted to the insulator 13, as in this embodiment.

When the second portion 32 of the insulator 13 rises on the side of the circuit board 11, the insulating property of the circuit board 11 is further improved by the second portion 32. Since the second portion 32 is substantially right-angled to the holding portions 23 of the holders 12a and 12b, the insulator 13 can have relatively high rigidity with respect to the holders 12a and 12b. In this way, even when the first portion 31 of the insulator 13 is pressed by the circuit board 11, the second portion 32 of the insulator 13 can reliably receive the holding portions 23.

In this embodiment, the third portion 33, which is an interposed portion, is next to a portion (i.e., fitting portion 35) supported by the holders 12a and 12b. Therefore, the insulator 13 is more strongly and reliably interposed between the circuit board 11 and the holders 12a and 12b. In this way, the fixation structure of the insulator 13 is further stabilized.

When the second portion 32 of the insulator 13 extends along the outlines of the holders 12a and 12b, it is possible to further improve the insulating property between the circuit board 11 and the holders 12a and 12b. This is particularly effective when the holders 12a and 12b are conductive members such as metal plates.

To make the insulator 13 be interposed between the circuit board 11 and the holders 12a and 12b, it is considered that fixing portions of the insulator 13 are provided so as to correspond to the fixing portions 15 of the circuit board 11, and the fixing portions of the insulator 13 and the fixing portions 15 of the circuit board 11 are fixed by screws. However, in this structure, the insulator 13 is interposed between the fixing portions of the circuit board 11 and the holders 12a and 12b. On the other hand, for example, the above-described embodiment can also be applied to the structure in which a conductive portion is provided on the first surface 11a of the circuit board 11 and directly makes contact with the holding portion 23 for ground connection.

It is preferable that the fixing portions 15 of the circuit board 11 directly make contact with the holders 12a and 12b in order to stably connect the circuit board 11 to the ground. According to the structure of this embodiment, it is possible to interpose the insulator 13 between the circuit board 11 and the holders 12a and 12b without interposing the insulator 13 between the fixing portions 15 of the circuit board 11 and the holders 12a and 12b. In this way, it is possible to stabilize the electrical characteristics of the circuit board 11.

### (Second embodiment)

Next, an electronic apparatus 51 according to a second embodiment will be described with reference to FIG. 16. Components having the same or similar functions as those of the first embodiment are denoted by the same reference numerals and a description thereof will not be repeated. In addition, structures other than the following structures are the same as those in the first embodiment.

The electronic apparatus 51 is, for example, a notebook PC. However, electronic apparatuses to which the embodiment can be applied are not limited thereto. The embodiment can be widely applied to various kinds of electronic apparatuses including a PDA (Personal Digital Assistant) and a game machine.

The electronic apparatus 51 includes a housing 2 and a mounting structure 52 in the housing 2. The mounting structure 52 includes a circuit board 11, an insulator 13, and holders 12a and 12b and has substantially the same structure as that of the first embodiment.

In the electronic apparatus 51 having the above-mentioned structure, it is possible to reduce the number of components, similar to the first embodiment.

The display apparatus 1 and the electronic apparatus 51 according to the first and second embodiments have been described above, but the embodiments are not limited thereto. The components according to the first and second embodiments may be appropriately combined with each other.

Six holding portions 23 or interposed portions 33 are not necessarily provided, but the number of holding portions 23 or interposed portions 33 may be smaller or greater than six. The position of the speaker 41 is not particularly limited. For example, the speaker 41 may be provided above the insulator 13. The second portion 32 of the insulator 13 may not necessarily face the holders 12a and 12b in a direction opposite to the first direction D1. The second portion 32 of the insulator 13 only needs to face the holders 12a and 12b in a direction in which it is pressed against the holders 12a and 12b, when the interposed portion 33 presses the first portion 31.

Next, one display apparatus will be described in addition.

A display apparatus according to an embodiment comprises (i) a housing, (ii) a supporting portion in the housing, (iii) a circuit board attached to the supporting portion, (iv) an insulating portion which comprises a first portion facing the circuit board and a second portion facing the supporting portion, and (v) an interposed portion interposed between the circuit board and the first portion of the insulating portion and pressing the first portion in a direction in which the second portion is pressed against the supporting portion.

## Claims

1. An electronic apparatus **characterized by** comprising:
a housing (2);
a holder (12a,12b) in the housing (2);
a circuit board (11) attached to the holder (12a,12b);
an insulator (13) comprising a first portion (31) facing the circuit board (11) and a second portion (32) facing the holder (12a,12b); and
an interposed portion (33) interposed between the circuit board (11) and the first portion (31) of the insulator (13) and pressing the first portion (31) in a direction in which the second portion (32) is pressed against the holder (12a,12b).

2. The display apparatus of claim 1, **characterized in that**
the first portion (31) of the insulator (13) faces the circuit board (11) in a first direction (D1), and
the second portion (32) of the insulator (13) faces the holder (12a,12b) in a second direction (D2) different from the first direction (Dl).

3. The display apparatus of claim 2, **characterized in that**
the second direction (D2) is opposite to the first direction (Dl).

4. The display apparatus of any one of claims 1 to 3, **characterized in that**
the interposed portion (33) is a portion of the insulator (13).

5. The display apparatus of any one of claims 1 to 3, **characterized in that**
the interposed portion (33) is a portion of the circuit board (11).

6. The display apparatus of any one of claims 1 to 5, **characterized in that**
the insulator (13) is a sheet, and
the interposed portion (33) and/or the second portion (32) is/are formed by bending a portion of the sheet.

7. The display apparatus of any one of claims 1 to 6, **characterized in that**
the insulator (13) has elasticity.

8. The display apparatus of any one of claims 1 to 7, **characterized by** further comprising:
a speaker (41) next to the insulator (13).

9. The display apparatus of any one of claims 1 to 8, **characterized in that**
the second portion (32) of the insulator (13) rises on a side of the circuit board (11).

10. The display apparatus of any one of claims 1 to 9, **characterized in that**
the second portion (32) of the insulator (13) extends along an outline of the holder (12a,12b).

11. The electronic apparatus of any one of claims 1 to 10, **characterized in that** the apparatus includes a display panel (3).

12. The display apparatus of claim 11, **characterized in that** the circuit board (11) is attached to the display panel (3) via the holder (12a,12b) such that the insulator (13) is disposed between the circuit board (11) and a rear surface (3b) of the the display panel (3), wherein the first portion (31) of the insulator (13) has a size that covers substantially the surface of the circuit board (11).

13. The electronic apparatus of any one of claims 1 to 12, **characterized in that** the apparatus is a display apparatus.

14. The electronic apparatus of any one of claims 1 to 12, **characterized in that** the apparatus is a portable electronic device.
